# EUROPÄISCHE PATENTANMELDUNG

(11) **EP 0 737 998 A2**
(43) Veröffentlichungstag der Anmeldung: **16.10.1996**
(21) Anmeldenummer: 96100953.7
(22) Anmeldetag: 24.01.1996
(51) Int. Cl.: H01J 37/34

(54) **Vorrichtung zum Aufbringen dünner Schichten auf ein Substrat**

(30) Priorität: 11.04.1995 DE 19513691
(71) Anmelder: Balzers und Leybold Deutschland Holding Aktiengesellschaft, 63450 Hanau (DE)
(72) Erfinder: Schuhmacher, Manfred, D-63755 Alzenau (DE); Winter, Erwin, D-63456 Hannau (DE); Sauer, Andreas, D-63768 Hösbach (DE); Marquardt, Dietmar, D-63256 Erlensee (DE); Teschner, Götz, D-63571 Gelnhausen (DE); Szczyrbowski, Joachim, Dr., D-63773 Goldbach (DE); Kunz, Hans, D-63594 Hasselroth II (DE); Skuk, Peter, D-61130 Nidderau (DE)

(57) **Zusammenfassung**

Bei einer Vorrichtung zum Aufbringen dünner Schichten auf ein Substrat (10) mittels des Kathodenzerstäubungsverfahrens in einer Vakuumkammer (1), durch die das zu beschichtende Substrat (10) hindurchbewegbar ist, sind von der Wand der Vakuumkammer (1) gehaltene Hohlprofile (6,7) parallel zur Kathodenebene und im Bereich zwischen der Kathode (12) und der Anode (4,5) vorgesehen, die von Kühlmittel und Prozeßgas durchströmt sind, wobei die Hohlprofile (6,7) sich quer zu den Kanälen erstreckende Öffnungen (6e, 6e', ...; 7e, 7e', ...) für den Austritt von Prozeßgas in die Vakuumkammer (1) aufweisen, wobei als Profilschienen mit L-förmigem Querschnitt ausgebildete Anoden (4,5) mit ihren kurzen Schenkeln (4a, 5a) jeweils die Hohlprofile (6,7) übergreifend auf den Oberseiten der Hohlprofile (6,7) abgestützt sind und wobei mehrschenklige Blenden (8,9) vorgesehen sind, deren einer Schenkel (8', 9') jeweils hakenförmig ausgebildet ist und entsprechend an den Prozeßkammerwänden (2,3) angeordnete Profile übergreift.

## Beschreibung

Die Erfindung betrifft eine Vorrichtung zum Aufbringen dünner Schichten auf ein Substrat mittels des Kathodenzerstäubungsverfahrens in einer Vakuumkammer, durch die das zu beschichtende Substrat hindurchbewegbar ist und mit einer zwischen einer zu zerstäubenden Kathode und einer Anode angeordneten Blende, wobei die Substratebene unterhalb der Anode verläuft und wobei von der Wand der Vakuumkammer gehaltene, mit Kanälen versehene Hohlprofile - parallel zur Kathodenebene und im Bereich zwischen der Kathode und der Anode - vorgesehen sind, die von einem Kühlmedium und von einem Prozeßgas durchströmt sind, wobei die Kanäle für das Prozeßgas Öffnungen aufweisen, die quer zur Längsachse dieses Kanals verlaufen und den Austritt von Prozeßgas in die Vakuumkammer ermöglichen.

Es ist eine Vorrichtung zum Aufbringen dünner Schichten auf ein Substrat mittels des Kathodenzerstäubungsverfahrens bekannt (EP 0 205 028). Hierbei ist zwischen der zu zerstäubenden Kathode und der Anode eine mechanische Blende vorgesehen, welche den Raum zwischen der Kathode und dem zu beschichtenden Substrat unterteilt. Diese Vorrichtung ist mit mehreren separaten Kühlrohren und Gasleitungsrohren für die Versorgung mit Temperiermedium und Prozeßgas versehen.

Diese bekannte Vorrichtung hat den Nachteil, daß die Zu- und Rückführung des Temperiermediums sowie die Versorgung mit Prozeßgas jeweils über separate, mehrstückige Rohrleitungen erfolgt und somit sehr anfällig für Betriebsstörungen und aufwendig in der Herstellung und Wartung ist. Die Rohrleitungen weisen nämlich Biegungen, Wicklungen, Schraubverbindungen und Lötstellen auf, die sich unter Betriebsbedingungen der Vorrichtung im Vakuum befinden, was durch zusätzlichen Einfluß von prozeßbedingter Wärme zu Haarrissen und Undichtigkeiten in den Rohrleitungen führt. Diese Undichtigkeiten (Lecks) beeinträchtigen zunächst die Schichtqualität, beispielsweise die Haftfähigkeit, der auf das Substrat aufzubringenden Schicht beim Zerstäubungsprozeß (Sputtern) und führen anschließend und zwangsläufig zum Total-Ausfall der Gesamtanlage, der immer mit erheblichem Aufwand und immensen Kosten verbunden ist.

Um die Betriebssicherheit spürbar zu erhöhen und damit die Ausfallzeiten zu reduzieren, die Herstellung und Wartung deutlich zu vereinfachen und damit eine wesentliche Reduzierung der Herstell- und Betriebskosten zu erreichen, hat man auch vorgeschlagen (DE 40 06 511 A1), sowohl das Temperiermedium als auch das Prozeßgas in Kanälen zu führen, die von einem einstückig und als Hohlprofil ausgeformten Bauteil gebildet sind, wobei Öffnungen für den Austritt des Gases quer zur Längsachse der Kanäle verlaufen, wobei die Anoden und Blenden unmittelbar mit dem Hohlprofil verschraubt sind.

Der vorliegenden Erfindung liegt nun die Aufgabe zugrunde, die bekannte Vorrichtung so zu verbessern, daß das Auswechseln der Anoden und Blenden leicht von der Oberseite der Prozeßkammer aus ohne Zuhilfenahme von Werkzeugen und ohne Blickkontakt erfolgen kann. Darüber hinaus sollen die Standzeit der Anoden und die thermische Belastbarkeit der Blenden verbessert werden.

Gemäß der vorliegenden Erfindung wird diese Aufgabe gelöst durch als Profilschienen mit L-förmigem Querschnitt ausgebildete Anoden, deren kurze Schenkel jeweils die Hohlprofile übergreifend auf den Oberseiten der Hohlprofile abgestützt sind und in dieser Lage von Bolzen gehalten sind, die sich von den Oberseiten aus nach oben zu erstrecken und mit Bohrungen in den kurzen Schenkeln korrespondieren.
Vorzugsweise weist jede etwa plattenförmige Blende an ihrem der Prozeßkammerwand zugewandten Abschnitt zwei Schenkel auf, von denen der eine Schenkel mit seiner Stirnfläche an der Prozeßkammerwand abgestützt ist und der andere Schenkel etwa hakenförmig ausgebildet ist und mit seinem freien Ende oder einer an diesem Ende angeordneten Nase eine an der Prozeßkammerwand befestigte Leiste oder ein Hohlprofil übergreift.

Weitere Einzelheiten und Merkmale sind in den Patentansprüchen näher beschrieben und gekennzeichnet.

Die Erfindung läßt die verschiedensten Ausführungsmöglichkeiten zu; eine davon ist in den anhängenden Zeichnungen schematisch näher dargestellt, und zwar zeigen:
- Figur 1: den Schnitt quer durch eine Kathodenstation mit an beiden Prozeßkammerwänden aufgebrachten Hohlprofilen und mit an den Hohlprofilen angehängten bzw. angeschraubten L-förmigen Anoden und mehrschenkligen Blenden,
- Figur 2: die Seitenansicht eines Teils eines Hohlprofils gemäß Figur 1, teilweise im Längsschnitt und

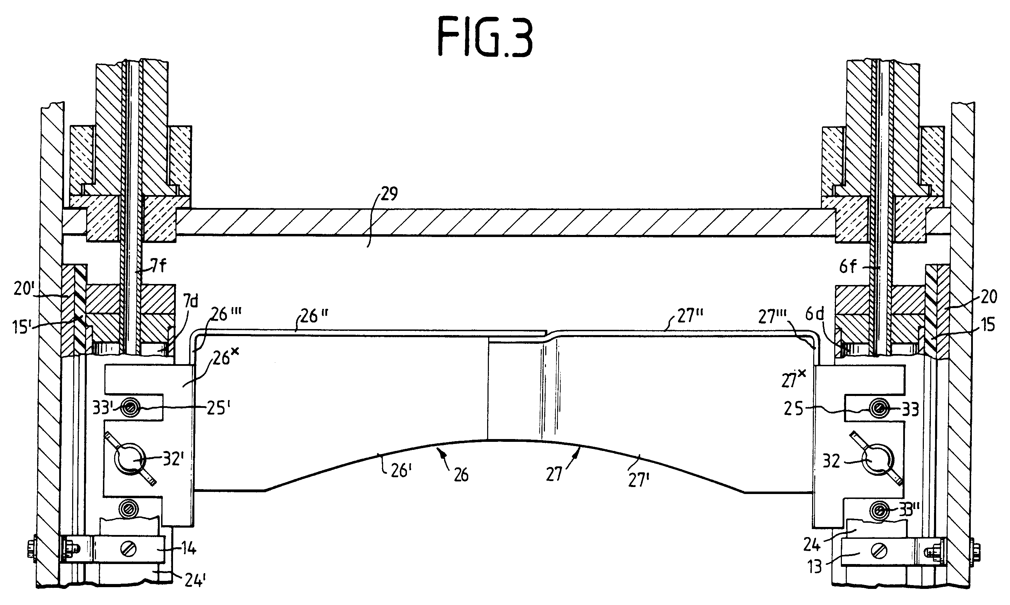

- Figur 3: die Draufsicht auf ein Stirnblenden-Paar gemäß der Kathodenstation nach Figur 1.

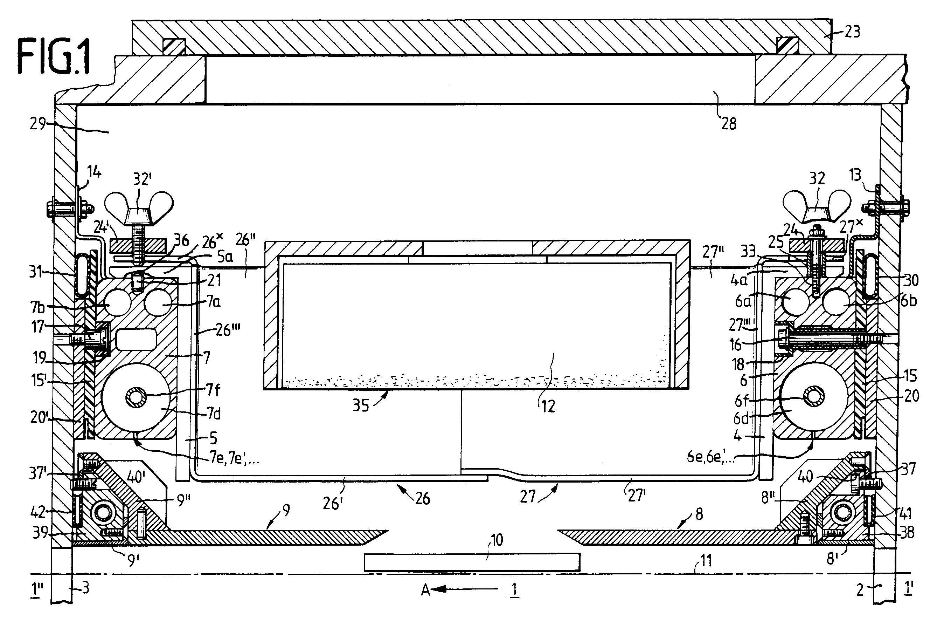

Wie Figur 1 zeigt, schließen sich seitlich der rechteckigen Vakuumkammer 1 noch weitere Vakuumkammern 1', 1'' an, die über Schleusen (nicht näher dargestellt) in den Prozeßkammerwänden 2, 3 in einer Linie miteinander verbunden sind.

In der Vakuumkammer 1 sind die Anoden 4, 5 parallel zueinander und quer zur Substrattransportrichtung und zur Erstreckungsrichtung der Kammern 1, 1' und 1'' so angeordnet, daß die rechteckigen Hohlprofile 6, 7 sowie die Blenden 8, 9 zur Kammermitte hin ausgerichtet sind, wobei die Kanäle für den Kühlmittelzulauf 6a, 7a und -rücklauf 6b, 7b in den Hohlprofilen angeordnet sind, in denen wiederum die Gasverteilerrohre 6f, 7f zentrisch befestigt sind. Weiterhin sind die Kanäle für Prozeßgas 6d, 7d, ... auf der Unterseite mit sich in bestimmten Abständen wiederholenden Öffnungen 6e, 6e', ...; 7e, 7e', ... für den Austritt des Prozeßgases aus den Kanälen 6d, 7d in die Vakuumkammer 1 versehen. Das Substrat 10 ist unterhalb der Anoden 4, 5 auf der sich horizontal erstreckenden Substratebene 11 und in der Bewegungsrichtung A durch die Vakuumkamner 1, 1', 1'', ...hindurch bewegbar.

Die Kathode 12 mit ihrem planen Target 35 befindet sich oberhalb und zwischen den Blenden 8, 9 und erstreckt sich parallel zu den Hohlprofilen 6, 7 und somit quer zur Bewegungsrichtung A des Substrats.

Die beiden Z-förmigen Dicht-/Leitbleche 13, 14 sind so angeordnet, daß sie die zwischen den Hohlprofilen 6, 7 und den Prozeßkammerwänden 2, 3 der Vakuumkammer 1 verbleibenden Spalte zusammen mit den Dichtschläuchen 30, 31 aus elastischem Werkstoff verschließen.

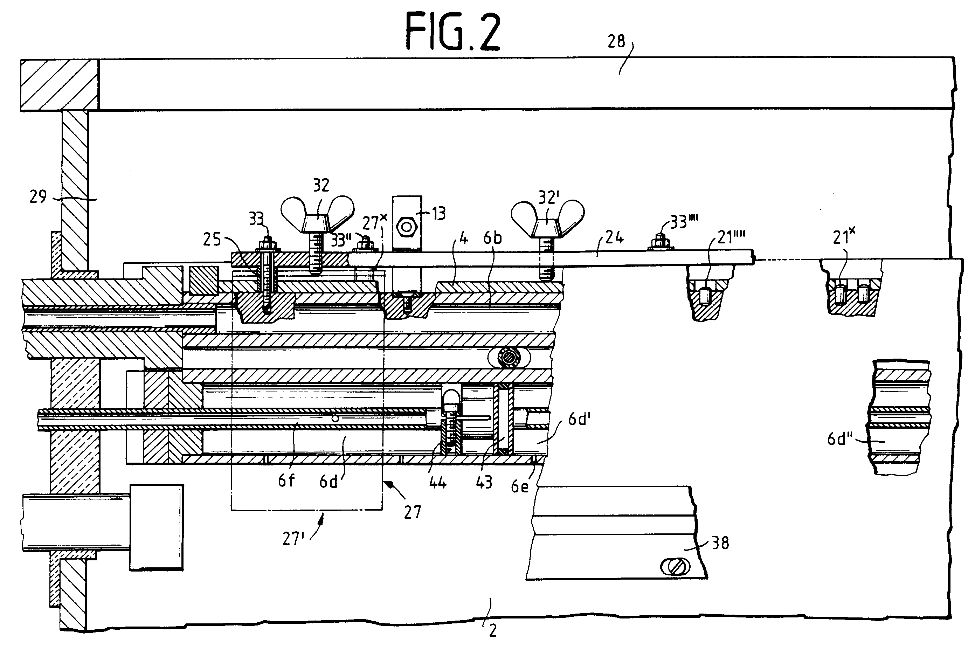

Die Hohlprofile 6, 7 sind über Isolierplatten 15, 15' elektrisch isoliert und mit Hilfe der Schrauben 16, 17 und Distanzplatten 20, 20' mit den Prozeßkammerwänden 2, 3 fest verbunden, wozu die Schrauben 16, 17 ihrerseits von Isolierbuchsen 18, 19 umschlossen sind. Die Anoden 4, 5 sind als L-Profile ausgeformt und liegen jeweils mit ihren kurzen Schenkeln 4a, 5a auf den oberen Flächen der Hohlprofile 6, 7 auf, wo sie mit Hilfe von in den Hohlprofilen 6, 7 verankerten Bolzen 21, 21', ... arretiert und mit Flügelschrauben 32, 32', ... festgeklemmt sind. Die Flügelschrauben 32, 32', ... , die durch die obere von einem Deckel 23 verschließbare Öffnung 28 gut zugänglich sind, werden dazu von Leisten 24, 24' gehalten, die ihrerseits - wie in Figur 2 gut ersichtlich ist - über Abstandsbuchsen 25, 25', ... mit den Hohlprofilen 6 bzw. 7 verschraubt sind. Die beiden Stirnwände 29, 29' jeder Prozeßkammer 1, 1', 1'', ... sind jeweils mit Hilfe von aus Blechzuschnitten geformten Blendenpaaren 26, 27 abgeschirmt, die ebenfalls auf der Oberseite der Rechteckprofile 6, 7 gehalten sind, wobei jede Blende 26, 27 jeweils aus einem Bodenteil 26', 27', einem Stirnwandteil 26'', 27'', einem Seitenwandteil 26 ''', 27''' und einem Kragenteil 26^{x}, 27^{x} besteht. Die sich jeweils oberhalb jedes Hohlprofils 6, 7 erstreckende Leiste 24, 24' weist jeweils eine Vielzahl von Gewindebohrungen für Flügelmuttern 32, 32', ... auf, deren Gewindebolzen auf den abgebogenen Schenkeln 4a bzw. 5a der Anoden 4, 5 aufliegen und diese unverrückbar auf den Hohlprofilen 6, 7 halten. Die Leisten 24, 24' ihrerseits sind mit Hilfe einer Reihe von Schrauben 33, 33', ... mit Abstandshülsen 25, 25', ... mit den Hohlprofilen 6 bzw. 7 verschraubt. Unterhalb jedes Hohlprofils 6, 7 ist jeweils eine Blende 8 bzw. 9 angeordnet, die im Wesentlichen aus einem sich parallel zur Kathode 12 bzw. dessen Targetfläche 35 erstreckenden ersten Schenkel 8' bzw. 9' und einem sich von diesem aus unter einem Winkel von etwa 45° nach oben zu erstreckenden hakenartigen zweiten Schenkel 8'' bzw. 9'' gebildet ist. Während der erste Schenkel 8' bzw. 9' mit seinem der Kathode 12 abgewandten Ende an der Prozeßkammerwand 2 bzw. 3 bzw. an einem sich parallel zum Hohlprofil 6 bzw. 7 erstreckenden Hohlprofil 38 bzw. 39 anliegt, übergreift jeweils das obere Ende des zweiten Schenkels 8'' bzw. 9'' mit einem nasenförmigen Ansatz 37, 37' die Oberseite des Hohlprofils 38 bzw. 39 bzw. dessen fingerartigen lotrecht stehenden Ansatz 40 bzw. 40', wobei das Hohlprofil 38, 39 mit der Prozeßkammerwand 2, 3 verschraubt ist und mit Hilfe eines Dichtschlauchs 41, 42 gegenüber der Prozeßkammerwand abgedichtet ist.

Wie Figur 2 zeigt, weist die Lanze bzw. das Gasverteilerrohr 6f bzw. 7f auf seiner Länge verteilt angeordnet, auf dem Rohr längsverschiebliche Sperrscheiben 43, 43', ... auf, die mit Hilfe von Klemmstücken 44, 44', ... an genau bestimmbaren Abschnitten des Gasverteilerrohres 6f bzw. 7f befestigbar sind, so daß die von den Sperrscheiben abgetrennten Partien oder Abschnitte 6d, 6d', ... bzw. 7d, 7d', ... einzeln mit Gas versorgt werden können, was es ermöglicht, die einzelnen Düsen 6e, 6e', ... bzw. 7e, 7e', ... mit unterschiedlichen Gasströmen zu versorgen. Die Kombination von Gasverteilerrohr, Sperrscheiben und Hohlprofil gestattet es also, die aus den Düsen 6e, 6e', ... bzw. 7e, 7e', ... austretenden Gasströme den Prozeßparametern anzugleichen, was eine besonders gleichmäßige Schichtverteilung auf dem Substrat 10 ermöglicht.

Bei bekannten Vorrichtungen des beschriebenen Typs werden die Anoden während des Sputtervorgangs vergleichsweise schnell mit einer isolierenden Schicht überzogen, was deren Standzeit wesentlich einschränkt. Die beschichteten Anoden müssen dann regelmäßig aus der Prozeßkammer ausgebaut und z.B. durch Sandstrahlen von der isolierenden Schicht befreit werden, was eine wesentliche Zeitverzögerung im Produktionsprozeß bedeutet. Die erfindungsgemäßen Anoden 4, 5 können aus Stahl hergstellt sein, was ihre Standzeit erhöht. Sie lassen sich besonders leicht nach dem Lösen der Flügelschrauben 32, 32', ... durch die Öffnung 28 aus der Kammer 1, 1', ... entfernen, was zu einer Verkürzung der Wartungszeit der Anlage führt. Bekannte Anoden sind mit Hilfe von Isolierbuchsen und Teflonstreifen an den Wänden der Prozeßkammer befestigt, die bis in den Bereich der Sputterzone hineinragen, was nach einer bestimmten Sputterzeit zu Funktionsproblemen führt, da diese Teile ungekühlt sind, mit der Folge, daß die bekannten Anoden thermisch nur gering belastbar sind.

### Bezugszeichenliste

- 1, 1', 1'': Vakuumkammer
- 2: Prozeßkammerwand
- 3: Prozeßkammerwand
- 4, 4a: Anode
- 5, 5a: Anode
- 6: Hohlprofil
- 6a: Kanal für Kühlmittelzulauf
- 6b: Kanal für Kühlmittelrücklauf
- 6c: Verbindungskanal für Kühlmittel
- 6d: Kanal für Prozeßgas
- 6e, 6e', ...: Öffnung
- 6f: Gasverteilerrohr
- 6g: Reduzierstück
- 6h: Reduzierstück
- 6i: Dichtring
- 6k: Öffnung
- 6l: Dichtring
- 7: Hohlprofil
- 7a: Kanal für Kühlmittelzulauf
- 7b: Kanal für Kühlmittelrücklauf
- 7c: Verbindungskanal für Kühlmittel
- 7d: Kanal für Prozeßgas
- 7e, 7e', ...: Öffnung
- 7f: Gasverteiler
- 7k: Öffnung
- 8, 8', 8'': Blende
- 9, 9', 9'': Blende
- 10: Substrat
- 11: Substratebene
- 12: Kathode
- 13: Dicht-/Leitblech
- 14: Dicht-/Leitblech
- 15, 15': Isolierplatte
- 16: Schraube
- 17: Schraube
- 18: Isolierbuchse
- 19: Isolierbuchse
- 20, 20': Distanzplatte
- 21, 21': Bolzen
- 22, 22': Flügelschraube
- 23: Deckel
- 24, 24': Leiste
- 25, 25': Abstandsbuchsen
- 26, 26',...26^{x}: Blende
- 27, 27',...27^{x}: Blende
- 28: Öffnung
- 29: Stirnwand
- 30: Dichtschlauch
- 31: Dichtschlauch
- 32, 32', ...: Flügelschraube
- 33, 33', ...: Schraube
- 35: Target
- 36, 36',...: Sacklochbohrung
- 37, 37': Nase
- 38: Hohlprofil
- 39: Hohlprofil
- 40, 40': Ansatz, Nase
- 41: Dichtschlauch
- 42: Dichtschlauch
- 43, 43', ...: Sperrscheibe
- 44, 44', ...: Klemmstück
- A: Bewegungsrichtung des Substrats

## Patentansprüche

1. Vorrichtung zum Aufbringen dünner Schichten auf ein Substrat (10) mittels des Kathodenzerstäubungsverfahrens in einer Vakuumkammer (1), durch die das zu beschichtende Substrat (10) hindurchbewegbar ist und mit einer zwischen einer zu zerstäubenden Kathode (12) und einer Anode (4,5) angeordneten Blende (8,9), wobei die Substratebene (11) unterhalb der Anode (4,5) verläuft, wobei von der Wand der Vakuumkammer (1) gehaltene, Kanäle (6a, 6b, 6d, 6f bzw. 7a, 7b, 7f, 7d) aufweisende Hohlprofile (6,7) parallel zur Kathodenebene und im Bereich zwischen der Kathode (12) und der Anode (4,5) vorgesehen sind, die vom Kühlmittel und Prozeßgas durchströmt sind, wobei die Hohlprofile (6,7) sich quer zu den Kanälen erstreckende Öffnungen (6e, 6e', ...;7e, 7e', ...) für den Austritt von Prozeßgas in die Vakuumkammer (1) aufweisen, **gekennzeichnet durch** als Profilschienen mit L-förmigem Querschnitt ausgebildete Anoden (4,5), deren kurze Schenkel (4a, 5a) jeweils die Hohlprofile (6,7) übergreifend auf den Oberseiten der Hohlprofile (6,7) aufliegen und in dieser Lage von Bolzen (21, 21', ...), Schrauben oder Klemmstücken gehalten sind, die sich von den Oberseiten der Hohlprofile (6,7) aus nach oben zu erstrecken und mit Bohrungen in den kurzen Schenkeln (4a, 5a) der Anoden korrespondieren.

2. Vorrichtung nach Anspruch 1, **dadurch gekennzeichnet**, daß die kurzen Schenkel (4a, 5a) der Anoden (4,6) mit Sacklochbohrungen (36, 36', ...) versehen sind, die mit den sich lotrecht erstreckenden Bolzen (21, 21', ...), Schrauben oder Klemmstücken zusammenwirken, die auf der Oberseite jedes Hohlprofils (6,7) fest angeordnet sind.

3. Vorrichtung nach Anspruch 1, **gekennzeichnet durch** eine sich parallel und im Abstand zur Oberseite der Hohlprofile (6,7) erstreckende ortsfeste Leiste (24, 24') mit einer in dieser angeordneten Gewindelochreihe für die Aufnahme von Schrauben (32, 32', ...), deren sich nach unten zu erstreckende Gewindebolzen die kürzeren Schenkel (4a, 5a) der L-förmigen Anoden (4,5) gegen deren Auflagefläche an den Hohlprofilen (6,7) drücken.

4. Vorrichtung nach Anspruch 1, **dadurch gekennzeichnet**, daß zwischen Hohlprofil (6,7) und Prozeßkammerwand (2,3) eine elektrisch isolierende Platte (15, 15') angeordnet ist, die gegenüber der Prozeßkammerwand (2,3) über einen Dichtschlauch (30,31) aus einem elastischen Werkstoff abgedichtet ist und die das Niederschlagen von abgesputterten Teilchen an der Prozeßkammerwand (2, 3) im Bereich des Hohlprofils (6,7) verhindert.

5. Vorrichtung zum Aufbringen dünner Schichten auf ein Substrat (10) mittels eines Kathodenzerstäubungsverfahrens in einer Vakuumkammer (1), durch die das zu beschichtende Substrat (10) hindurchbewegbar ist und mit einer zwischen einer zu zerstäubenden Kathode (12) und einer Anode (4,5) angeordneten Blende (8,9), wobei die Substratebene (11) unterhalb der Anode (4,5) verläuft und wobei von der Wand der Vakuumkammer (1) gehaltene, Kanäle (6a, 6b, 6d, 6f bzw. 7a, 7b, 7f, 7d) aufweisende Hohlprofile (6,7) parallel zur Kathodenebene und im Bereich zwischen der Kathode (12) und der Anode (4,5) vorgesehen sind, die von einem Kühlmittel und von Prozeßgas durchströmt sind, wobei die Hohlprofile (6,7) sich quer zu den Kanälen erstreckende Öffnungen (6e, 6e', ...; 7e, 7e', ...) für den Austritt von Prozeßgas in die Vakuumkammer (1) aufweisen, **dadurch gekennzeichnet**, daß jede etwa plattenförmige Blende (8, 9) an ihrem der Prozeßkammerwand (2, 3) zugewandten Abschnitt zwei Schenkel (8', 8'' bzw. 9', 9'') aufweist, von denen der eine Schenkel (8', 9') mit seiner Stirnfläche an der Prozeßkammerwand (2, 3) abgestützt ist und der andere Schenkel (8'', 9'') etwa hakenförmig ausgebildet ist und mit seinem freien Ende oder einer an diesem Ende angeordneten Nase (37, 37') eine an der Prozeßkammerwand befestigte Leiste oder Hohlprofil (38, 39) übergreift.

6. Vorrichtung nach Anspruch 5, **dadurch gekennzeichnet**, daß die Blende (8 bzw. 9) aus einem etwa rechteckigen Blechzuschnitt gebildet ist, der auf seiner der Kathode (12) zugewandten oberen Seitenfläche mit einer sich parallel zur die Blendenöffnung begrenzenden Längskante erstreckenden Leiste, Lappen oder Schenkel (8'' bzw. 9'') versehen ist, der sich gegenüber der Blendenebene in einem Winkel von etwa 45° nach oben und in Richtung auf die Prozeßkammerwand (2 bzw. 3) zu erstreckt, wobei die obere freie Kante dieses Schenkels (8'' bzw. 9'') mit einer oder mehreren Nasen (37, 37', ...) versehen ist, die sich vom Schenkel aus lotrecht nach unten zu erstrecken und die einen oder mehrere Ansätze (40, 40', ...) übergreifen, die an einer Leiste oder einem Hohlprofil (38 bzw. 39) vorgesehen sind, das an der Prozeßkammerwand (2 bzw. 3) fest angeordnet ist.

7. Vorrichtung nach einem oder mehreren der vorhergehenden Ansprüche, **dadurch gekennzeichnet**, daß das Hohlprofil (6 bzw. 7) einen Längskanal (6d bzw. 7d) aufweist, durch den sich eine Lanze oder Rohr (6f bzw. 7f) koaxial erstreckt, auf dem Sperrscheiben (43, 43', ...) längsverschiebbar und arretierbar angeordnet sind, durch die der Längskanal (6d bzw. 7d) in einzelne Abschnitte oder Kammern (6d, 6d', ... bzw. 7d, 7d', ...) aufteilbar ist und die über das Rohr (6f bzw. 7f) mit Prozeßgas versorgbar sind, wobei die einzelnen Kammern über Düsen (6e, 6e', ... bzw. 7e, 7e', ...) mit der Vakuumkammer (1) in Verbindung stehen.
